(19) Europäisches Patentamt
European Patent Office
Office européen des brevets

(11) **EP 3 556 017 B1**

(12) **FASCICULE DE BREVET EUROPEEN**

(45) Date de publication et mention
de la délivrance du brevet:
**06.01.2021 Bulletin 2021/01**

(21) Numéro de dépôt: **17816491.9**

(22) Date de dépôt: **23.11.2017**

(51) Int Cl.:
***H03K 17/975*** (2006.01)       ***H03K 17/955*** (2006.01)
***H03K 17/96*** (2006.01)

(86) Numéro de dépôt international:
**PCT/EP2017/080166**

(87) Numéro de publication internationale:
**WO 2018/108476 (21.06.2018 Gazette 2018/25)**

(54) **DISPOSITIF ET PROCEDE DE DETECTION DE L'APPROCHE ET/OU DE CONTACT, ET DE L'APPUI D'UN OBJET, RELATIVEMENT A UNE SURFACE DE DETECTION**

VORRICHTUNG UND VERFAHREN ZUR ERFASSUNG DER ANNÄHERUNG UND/ODER BERÜHRUNG UND DES DRUCKS EINES OBJEKTS IN BEZUG AUF EINE ERFASSUNGSFLÄCHE

DEVICE AND METHOD FOR DETECTING THE APPROACH AND/OR CONTACT AND PRESSURE OF AN OBJECT IN RELATION TO A DETECTION SURFACE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.12.2016 FR 1662614**

(43) Date de publication de la demande:
**23.10.2019 Bulletin 2019/43**

(73) Titulaire: **Fogale Nanotech
30900 Nîmes (FR)**

(72) Inventeurs:
 • **NEEL, Christian
   30900 Nîmes (FR)**
 • **OSSART, Frédéric
   30980 Langlade (FR)**
 • **ROZIERE, Didier
   30900 Nîmes (FR)**

(74) Mandataire: **IPAZ
Parc Les Algorithmes, Bâtiment Platon
CS 70003 Saint-Aubin
91192 Gif-sur-Yvette Cedex (FR)**

(56) Documents cités:
WO-A1-2013/093326       WO-A1-2013/093326
WO-A2-2015/144474       JP-B2- 5 888 686

## Description

### Domaine technique

La présente invention concerne un dispositif de détection d'une part de l'approche et du contact dudit objet avec la surface de détection, et d'autre part de l'appui dudit objet sur ladite surface. Elle concerne également un procédé mettant en œuvre un tel dispositif.

Le domaine de l'invention est, de manière non limitative, celui des interfaces de détection capacitive d'objets pour appareil électronique, permettant audit appareil de détecter les objets environnants, en particulier dans le domaine de la robotique.

### Etat de la technique

Les appareils électroniques interagissent avec leur environnement de manière de plus en plus autonome. Cette interaction autonome nécessite, le plus souvent, la possibilité de détecter les objets/personnes se trouvant à proximité ou au contact de l'appareil, en particulier lorsque ledit appareil est un robot, qu'il soit mobile ou non. Une telle détection d'approche et de contact est réalisée grâce à une surface de détection équipée de capteurs de détection d'approche et/ou de contact, en particulier capacitifs.

Pour parfaire cette interaction, il parait nécessaire de détecter, en plus de l'approche et du contact, un appui, une force ou une pression exercée par un objet sur une surface de détection de l'appareil. Il existe actuellement des capteurs de détection d'un appui sur une surface de détection d'un appareil.

Cependant, l'ajout d'un tel capteur de détection d'appui dans une surface de détection, déjà équipée de capteurs d'approche et de contact, s'avère coûteux, encombrant et complexe. De plus, la juxtaposition de capteurs dédiés à la détection d'approche et de contact et de capteurs dédiés à la détection d'un appui créé des interférences mutuelles dégradant le fonctionnement et l'efficacité de ces capteurs.

Le document WO2013/093326 A1 décrit un capteur de détection capacitif selon l'état de la technique.

Un but de la présente invention est de remédier aux inconvénients précités.

Un autre but de la présente invention est de proposer un unique dispositif capteur permettant de détecter d'une part l'approche et/ou le contact, et d'autre part l'appui d'un objet sur une surface de détection, et/ou la force ou la pression exercée par cet objet sur la surface de détection.

Encore un autre but de la présente invention est de proposer un unique dispositif capteur permettant de détecter d'une part l'approche et/ou le contact, et d'autre part un appui, une force ou une pression, moins encombrant, moins coûteux et moins complexe comparé à une juxtaposition de deux capteurs existants l'un dédié à la détection d'approche et de contact et l'autre dédié à la détection d'appui, de force ou de pression.

Encore un autre but de la présente invention est de proposer un unique dispositif capteur permettant de détecter d'une part l'approche et/ou le contact, et d'autre part un appui, une force ou une pression, avec une grande fiabilité et une bonne sûreté de fonctionnement.

### Exposé de l'invention

Au moins un de ces buts est atteint avec un dispositif de détection d'un objet par rapport à une surface de détection, comprenant :

- au moins une électrode, dite de mesure, et
- au moins une deuxième électrode, disposée face à ladite électrode de mesure ;
  lesdites électrodes sont séparées d'une distance élastiquement modifiable, en particulier localement, par une pression exercée par ledit objet sur ladite surface de détection ; ledit dispositif comprenant au moins un module de commande agencé pour :

  - appliquer auxdites électrodes :

    - un même potentiel alternatif, dit de garde, ou
    - des potentiels alternatifs sensiblement identique(s);

  différent(s) d'un potentiel de masse, de sorte à mesurer un premier signal électrique relatif à une capacité, dite électrode-objet, entre ladite électrode de mesure et ledit objet, représentatif d'une approche et d'un contact dudit objet avec ladite surface de détection; caractérisé en ce que ledit moyen de commande est en outre agencé pour

- appliquer à ladite deuxième électrode :

  - un deuxième potentiel proportionnel au potentiel de garde et d'amplitude différente, ou
  - le potentiel de masse,

de sorte à mesurer un deuxième signal électrique relatif à la capacité, dite totale, vue par ladite électrode de mesure, représentatif d'un appui, d'une force ou d'une pression, exercé(e) par ledit objet avec ladite surface de détection.

Ainsi, le dispositif selon l'invention permet de mesurer, avec une unique électronique de mesure et un unique ensemble d'électrodes, d'une part un premier signal représentatif d'une première information qui est l'approche et le contact d'un objet avec la surface de détection, et d'autre part un deuxième signal représentatif d'une deuxième information qui est l'appui, la force ou la pression, exercé(e) par l'objet sur la surface de détection.

Par conséquent, le dispositif selon l'invention est moins coûteux, moins encombrant et moins complexe à mettre en œuvre comparé à une juxtaposition de deux capteurs dédiés, l'un à la détection d'approche et de contact, et l'autre à la détection d'appui. De plus, le dispositif selon l'invention présente une meilleure performance en détection comparée à une configuration utilisant deux capteurs indépendants pouvant interférer l'un sur l'autre.

Suivant des modes de réalisation, le module de commande peut en outre être agencé pour appliquer le deuxième potentiel ou le potentiel de masse à la deuxième électrode de sorte à mesurer le deuxième signal électrique relatif à la capacité totale lorsque la capacité électrode-objet atteint une capacité seuil prédéterminée, ou se trouve dans une gamme de capacités seuil prédéterminée, représentative d'un contact entre ledit objet et ladite surface de détection.

Bien entendu, le déclanchement de la mesure du premier et du deuxième signal électrique peuvent être également effectuée en fonction d'autres critères, ou simplement de manière périodique ou alternée.

Un potentiel électrique peut être appliqué à des électrodes, de manière non limitative, en reliant électriquement ces électrodes à ce potentiel, ou en soumettant ces électrodes, directement ou par l'intermédiaire de composants électroniques et/ou de pistes ou de fils de liaison et/ou de tout autre moyen de couplage électrique (champ électrique, induction), à ce potentiel électrique ou à une source générant ce potentiel électrique.

De même, dans le cadre de l'invention, polariser électriquement des électrodes à un potentiel électrique peut signifier par exemple soumettre ces électrodes au potentiel électrique, ou appliquer le potentiel électrique aux électrodes.

On définit un potentiel de masse comme un potentiel de référence pour l'électronique ou une partie de l'électronique. Un potentiel de masse peut également correspondre à une terre ou un potentiel de terre.

Les potentiels électriques peuvent être définis, sans perte de généralité, par rapport à une référence électrique qui peut être le point de référence de la source qui les génèrent, ou un potentiel de référence général tel qu'un potentiel de masse.

Un potentiel alternatif peut être défini comme un potentiel variable dans le temps avec au moins une composante fréquentielle à une fréquence non-nulle.

Le potentiel de garde peut ainsi être défini (ou référencé), de manière non limitative, par rapport au potentiel de masse. Dans ce cas, le potentiel de garde peut correspondre également à une différence de potentiel par rapport au potentiel de masse considéré comme nul.

Suivant des modes de mise en œuvre, le potentiel de garde peut être de toutes formes, et notamment sinusoïdales, carrées, triangulaires, .... Ce potentiel peut être généré de manière directe, ou en utilisant des techniques de modulation de largeur d'impulsions (PWM).

Dans le cadre de la présente invention, des potentiels alternatifs appliqués à des électrodes (telles qu'une électrode de mesure et une deuxième électrode) peuvent être considérés comme sensiblement identiques lorsqu'ils ne génèrent pas (avec l'électronique de mesure mise en œuvre) de mesures de capacité exploitables entre ces électrodes. On peut notamment citer comme exemples de potentiels électriques alternatifs identiques ou sensiblement identiques :

- des potentiels alternatifs ayant une même forme temporelle (sinusoïdale, carrée, triangulaire, ...), une même amplitude de variation et une même phase (ou en d'autres termes variant de manière synchrone);
- des potentiels alternatifs qui comportent au moins une composante spectrale identique en amplitude et en phase à au moins une fréquence de travail ;

Il est à noter que les électrodes peuvent être polarisées, ou soumises à un potentiel global, correspondant à une superposition d'un potentiel électrique alternatif dit « de garde » identique ou sensiblement identique pour chaque électrode et d'autres potentiels avec d'autres composantes éventuellement différentes pour chaque électrode mais qui ne génèrent pas de mesure de capacité exploitable avec l'électronique de mesure mise en œuvre.

Ainsi, suivant les modes de mise en œuvre de l'électronique de mesure tels qu'ils seront détaillés plus loin, la capacité électrode objet peut être mesurée en appliquant respectivement à une électrode de mesure et à une deuxième électrode des potentiels globaux comprenant un potentiel électrique alternatif de garde identique, et des composantes différentes telles qu'une composante continue, ou une composante fréquentielle qui ne se trouve pas dans la bande passante de détection de l'électronique de mesure, ou encore une composante avec une forme d'onde orthogonale au sens du produit scalaire à celle du potentiel de garde (c'est-à-dire dont la somme des produits terme-à-terme est nulle).

Le deuxième potentiel correspond à un potentiel qui, lorsqu'il est appliqué à une deuxième électrode, génère (avec l'électronique de mesure mise en œuvre) une mesure de capacité entre une électrode de mesure (au potentiel de garde) et cette deuxième électrode. Pour cela il doit être d'amplitude différente du potentiel de garde. Il peut aussi être d'amplitude nulle, auquel cas il correspond au potentiel de masse.

Le deuxième potentiel est en outre défini comme proportionnel au potentiel de garde. Cela signifie qu'il comprend une composante identique en termes de forme d'onde et/ou de fréquence et de phase au potentiel de garde, mais, comme expliqué précédemment, d'amplitude différente. Cette amplitude est de préférence inférieure à l'amplitude du potentiel de garde, mais elle peut également être supérieure. Ainsi, on peut notamment citer comme exemples de deuxièmes potentiels:

- un potentiel alternatif ayant une même forme temporelle (sinusoïdale, carrée, triangulaire, ...), une même phase (ou en d'autres termes variant de manière synchrone) que le potentiel de garde, mais une amplitude de variation différente ;
- un potentiel alternatif qui comportent au moins une composante spectrale de même phase à au moins une fréquence de travail, mais d'amplitude différente ;

Le fait d'appliquer un deuxième potentiel d'amplitude non-nulle au lieu d'un potentiel de masse à une deuxième électrode permet en quelques sorte d'ajuster un gain ou une sensibilité de mesure de la capacité totale qui peut être très supérieure à la capacité électrode-objet :

- en appliquant le potentiel de masse à une deuxième électrode, on obtient entre une électrode de mesure et cette deuxième électrode une différence de potentiel correspondant au potentiel de garde ;
- en appliquant un deuxième potentiel proportionnel au potentiel de garde et d'amplitude non-nulle à une deuxième électrode, on peut obtenir (pour un choix d'amplitude adapté) entre une électrode de mesure et cette deuxième électrode une différence de potentiel inférieure au potentiel de garde.

Bien entendu, comme précédemment, il est à noter que les électrodes de mesure et deuxième électrodes peuvent être polarisées, ou soumises à un potentiel global, correspondant à une superposition, respectivement, d'un potentiel de garde ou d'un deuxième potentiel, et d'autres potentiels avec d'autres composantes éventuellement différentes pour chaque électrode mais qui ne génèrent pas de mesure de capacité exploitable avec l'électronique de mesure mise en œuvre.

Le dispositif selon l'invention peut comprendre une électronique de mesure reliée à l'électrode de mesure et permettant de mesurer le premier signal relatif à la capacité électrode-objet et le deuxième signal relatif à la capacité totale.

Avantageusement, ce premier signal relatif à la capacité électrode-objet et ce deuxième signal relatif à la capacité totale, vus par l'électrode de mesure, peuvent être mesurés au niveau d'un même point de mesure.

Ainsi, la mise en œuvre du dispositif selon l'invention est simplifiée.

Suivant des modes de réalisation, le dispositif selon l'invention peut comprendre une électronique de mesure avec un circuit implémentant un amplificateur opérationnel avec une impédance comprenant une composante capacitive en contre réaction, la ou les électrodes de mesure étant reliées à l'entrée négative dudit amplificateur opérationnel.

L'électronique de mesure peut ainsi par exemple implémenter un amplificateur de charge avec une capacité en contre-réaction.

Le circuit implémentant un amplificateur opérationnel peut être réalisé sous toute forme, notamment analogique ou numérique, permettant de réaliser une fonction d'amplificateur opérationnel.

On rappelle qu'un amplificateur opérationnel est un modèle de composant bien connu de l'homme du métier avec une entrée positive et une entrée négative d'impédances idéalement infinies, et qui génère en sortie un signal correspondant à la différence des potentiels appliqués sur les entrées amplifiée avec un gain idéalement infini.

Le dispositif selon l'invention peut également comprendre une électronique de mesure avec un circuit implémentant un circuit de conversion de charges en signal électrique ou numérique (capacité commutée...).

Suivant des modes de réalisation, le circuit implémentant un amplificateur opérationnel peut être alimenté par une alimentation électrique référencée au potentiel de garde.

Suivant d'autres modes de réalisation, le circuit implémentant un amplificateur opérationnel peut être alimenté par une alimentation électrique référencée à la masse.

Suivant des modes de réalisation, le dispositif selon l'invention peut comprendre une électronique de mesure avec au moins un moyen de démodulation mettant en œuvre l'un au moins des éléments suivants :

- un démodulateur synchrone ;
- un détecteur d'amplitude ;
- un démodulateur numérique.

De manière générale, un démodulateur synchrone peut se modéliser par (ou comprendre) un multiplicateur qui effectue une multiplication du signal de mesure avec le signal de porteuse et un filtre passe-bas.

Le signal de porteuse peut être, ou comprendre, ou être dérivé du potentiel de garde (ou du moins de la différence de potentiel entre la masse et le potentiel de garde).

Un détecteur d'amplitude (ou démodulateur asynchrone) peut se modéliser par (ou comprendre) un élément de redressement tel qu'un redresseur à diodes, des commutateurs à switchs ou un détecteur quadratique, et un filtre passe-bas. Il permet d'obtenir l'amplitude du signal de mesure modulé issu du détecteur de courant.

Les moyens de démodulation peuvent également comprendre des filtres passe-bande ou passe-bas anti-repliement placés avant la démodulation.

Bien entendu, les moyens de démodulation peuvent être réalisés sous forme numérique et/ou analogique. Ils peuvent notamment comprendre un convertisseur analogique-numérique et un microprocesseur et/ou un FPGA qui effectue numériquement une démodulation synchrone, une détection d'amplitude ou toute autre opération de démodulation.

Le dispositif selon l'invention peut comprendre au moins un commutateur commandable, tel qu'un interrupteur, commandé par le module de commande, et qui :

- dans une première position : relie l'au moins une deuxième électrode au potentiel de garde ; et
- dans une deuxième position : relie l'au moins une deuxième électrode au potentiel de masse ou au deuxième potentiel.

Dans des modes de réalisation mettant en œuvre plusieurs deuxièmes électrodes, le commutateur commandable peut être agencé :

- de sorte à relier toutes les deuxièmes électrodes simultanément soit au potentiel de garde, soit au potentiel de masse ou au deuxième potentiel; ou
- de sorte à relier sélectivement une ou une pluralité de deuxièmes électrodes au potentiel de masse ou au deuxième potentiel, et les autres deuxièmes électrodes au potentiel de garde ;

Suivant un exemple de réalisation, le dispositif selon l'invention peut avantageusement comprendre une unique source fournissant le potentiel de garde à toutes les électrodes.

Alternativement, le dispositif selon l'invention peut comprendre :

- une première source fournissant le potentiel de garde à l'au moins une électrode de mesure, et
- une deuxième source fournissant le potentiel de garde à l'au moins une deuxième électrode, lors de la mesure du premier signal, et, le cas échéant, fournissant le deuxième potentiel à l'au moins une deuxième électrode lors de la mesure du deuxième signal.

Suivant des modes de réalisation, la deuxième source peut être indépendante de la première source, ou dépendante ou asservie à la première source, ou partager des éléments communs (tel qu'un oscillateur ou un générateur d'ondes) avec la première source.

Dans un premier exemple de réalisation, la deuxième source est allumée lors de la mesure du premier signal de sorte à fournir le potentiel de garde, et lors de la mesure du deuxième signal de sorte à fourni le deuxième potentiel. En particulier, l'amplitude de la deuxième source peut être contrôlée par le moyen de commande.

Dans un second exemple de réalisation, la deuxième source est allumée lors de la mesure du premier signal et éteinte lors de la mesure du deuxième signal. En particulier, la deuxième source peut être allumée et éteinte par le moyen de commande.

Dans un autre exemple de réalisation, la deuxième source peut être maintenue allumée à tout moment. Dans ce cas, le dispositif selon l'invention peut comprendre un commutateur commandable reliant l'au moins une deuxième électrode :

- à la deuxième source lors de la mesure du premier signal ; et
- à la masse lors de la mesure du deuxième signal.

Ce commutateur commandable peut en particulier être commandé par le moyen de commande.

Le module de commande peut être un processeur ou une puce électronique configurée pour réaliser les opérations de commandes décrites. Un tel processeur, ou une telle puce électronique, peut être dédié(e) ou non à la réalisation desdites opérations de commandes.

Avantageusement, le dispositif selon l'invention peut en outre comprendre au moins un module de calcul configuré pour calculer une capacité, dite inter-électrodes, entre ladite électrode de mesure et ladite deuxième électrode, en fonction de ladite capacité totale et de ladite capacité électrode-objet.

Un tel module de calcul peut être configuré pour calculer la capacité inter-électrodes $C_{ie}$ par soustraction, dans la capacité totale $C_T$, de ladite capacité électrode-objet $C_{eo}$ selon la relation suivante :

$$C_{ie} = C_T - C_{eo}$$

Suivant des modes de réalisation, la capacité électrode-objet peut être obtenue à partir d'une mesure préalable. Il peut également s'agir d'une mesure mémorisée.

Lorsque la mesure de capacité totale est réalisée en fonction de la comparaison de la capacité électrode-objet avec une capacité seuil $C_s$ ou une gamme de capacités seuil prédéterminée, on peut utiliser cette capacité seuil $C_s$ comme valeur de capacité électrode-objet pour calculer la capacité inter électrodes.

Cette capacité seuil peut être fixe, par exemple prédéterminée en usine.

Cette capacité seuil peut également être adaptative. Dans ce cas, elle peut être déterminée ou mise à jour par exemple en fonction de mesures précédentes, d'un historique de mesures et/ou d'un environnement de mesure tel que cela sera détaillé plus loin.

Le dispositif selon l'invention peut en outre comprendre au moins un module de calcul configuré pour :

- déterminer une distance ou un contact (ou un quasi-contact) entre l'objet et la surface de détection en fonction du premier signal (et/ou une vitesse, une trajectoire, un mouvement, un geste,...); et/ou
- déterminer une pression, une force ou un appui appliqué par ledit objet sur la surface de détection en fonction du deuxième signal.

L'au moins un module de calcul peut déterminer ladite distance (ou contact), respectivement ladite pression (ou force ou appui), par calcul ou par comparaison avec une table de référence préalablement établie.

L'au moins un module de calcul peut déterminer ladite distance ou contact :

- directement en fonction du premier signal mesuré ou d'une version numérisée dudit signal ; ou
- d'une valeur de capacité électrode-objet déduite dudit premier signal, mesuré ou numérisé.

L'au moins un module de calcul peut déterminer ladite pression ou force ou appui) :

- directement en fonction du deuxième signal mesuré ou d'une version numérisée dudit signal ; ou
- d'une valeur de capacité totale déduite dudit deuxième signal, mesuré ou numérisé ; ou
- d'une valeur de capacité inter-électrodes, calculée en fonction de ladite capacité totale et de la capacité seuil.

Avantageusement, l'électrode de mesure et la deuxième électrode peuvent être séparées par une couche élastiquement compressible, en particulier localement, comprenant, ou formée par, un matériau diélectrique.

Le matériau diélectrique peut par exemple comprendre :

- un fluide diélectrique, tel que de l'huile ;
- un polymère diélectrique, tel qu'un polymère à base de silicone ; ou
- une mousse diélectrique, telle qu'une mousse en polyester ou en silicone.

Suivant des modes de réalisation, le dispositif selon l'invention peut comprendre une ou des électrodes de mesure et/ou deuxième électrodes réalisées par exemple :

- à partir d'un dépôt d'encre conductrice, déposée par exemple avec un procédé de sérigraphie ou de jet d'encre, sur une surface de matériau diélectrique ;
- à partir de couches de matériaux métalliques comme du cuivre, argent, ou d'autres matériaux conducteurs tels que du carbone ou des oxydes métalliques (Oxyde d'Indium Etain ou ITO, oxyde de zinc ou ZnO) déposées par un procédé de dépôt sous vide ou gravées par un procédé de gravure ;
- à partir de circuit imprimé ou similaire, rigide, semi rigide ou souple (diélectrique epoxy, polyimide, PET....), avec une seule ou plusieurs couches de métal... ;

- avec des polymères conducteurs ;
- sous la forme de tissu ou de couches de tissu, avec des fils en matériau conducteur (métal, ...) tissés ou tricotés....

Suivant des modes de réalisation, le dispositif selon l'invention peut comprendre une ou des électrodes de mesure et/ou deuxièmes électrodes transparentes. De telles électrodes peuvent être réalisées par exemple avec un dépôt d'oxyde conducteur transparent, tel que par exemple un Oxyde d'Indium Etain (ou ITO), sur une couche de polymère diélectrique transparent tel que du Polytéréphtalate d'éthylène (PET).

Les pistes de liaison de l'une au moins des électrodes de mesure et deuxièmes électrodes peuvent être également être transparente.

La couche élastiquement compressible de séparation peut également être réalisée en matériau diélectrique transparent. A cet effet, elle peut être réalisée, par exemple, en plastique souple transparent ou en PolyDiMethylSiloxane (ou PDMS).

Alternativement ou en plus, l'électrode de mesure peut être disposée sur, ou dans, ou sous, un support, réalisé en un matériau souple, tel qu'un tissu (par exemple une structure tissée ou tricotée), placé au-dessus et à distance de la deuxième électrode, et se déformant au moins localement lorsqu'une pression est exercée sur ledit support.

Dans ce cas, la ou les électrodes de mesure peuvent être réalisées par exemple dans un tissu, ou sous forme de tissu ou de couches de tissu, avec des fils en matériau conducteur (métal, ...) tissés ou tricotés....

Le dispositif selon l'invention peut comprendre plusieurs électrodes de mesures.

Le dispositif selon l'invention peut comprendre en particulier une pluralité d'électrodes de mesure distribuées dans le plan de la surface de détection.

Suivant des modes de réalisation, le dispositif selon l'invention peut comprendre une ou des deuxièmes électrodes agencées selon l'une au moins des configurations suivantes :

- au moins une deuxième électrode disposée en regard de plusieurs, en particulier de toutes les, électrodes de mesure ;
- pour au moins une, en particulier chaque, électrode de mesure, une deuxième électrode disposée en regard de ladite électrode de mesure ;
- pour au moins une, en particulier chaque, électrode de mesure, plusieurs deuxièmes électrodes disposées en regard de ladite électrode de mesure.

Suivant des modes de réalisation, le dispositif selon l'invention peut comprendre en outre au moins une électrode de garde additionnelle polarisée au potentiel de garde.

Dans ce cas, les deuxièmes électrodes peuvent être disposées dans, ou sur, un plan, dit de garde, ledit plan de garde comprenant la ou les électrodes de garde additionnelles.

Suivant un mode de réalisation, le dispositif selon l'invention peut comprendre :

- une matrice d'électrodes de mesure, organisée en lignes-colonnes ; et
- en regard de chaque ligne, respectivement chaque colonne, d'électrodes de mesure, au moins une ligne, respectivement une colonne, constituée d'une ou plusieurs deuxième(s) électrode(s).

Dans ce cas les deuxièmes électrodes d'une même ligne, respectivement d'une même colonne, peuvent être au même potentiel. Autrement dit, le potentiel des deuxièmes électrodes d'une même ligne, respectivement d'une même colonne, est ajustée/modifiée de manière commune.

Lorsque les deuxièmes électrodes sont disposées dans, ou sur, un plan de garde, ce dernier peut être mis au potentiel de l'électrode de mesure.

Suivant des modes de réalisation, le dispositif selon l'invention peut comprendre plusieurs électrodes de mesure, et un commutateur d'électrodes permettant de relier sélectivement une électrode de mesure, dite « électrode active », à l'électronique de mesure, ledit commutateur d'électrodes étant en outre agencé pour polariser les autres électrodes de mesures au même potentiel électrique que l'électrode active.

Le commutateur d'électrodes peut permettre en particulier de sélectionner séquentiellement une pluralité de, ou toutes les, électrodes de mesure comme électrode active.

Il permet ainsi d'utiliser une électronique de mesure (ou une voie de mesure) pour effectuer une mesure séquentiellement avec plusieurs électrodes de mesures.

Ainsi, un dispositif selon l'invention avec une pluralité d'électrodes de mesure peut comprendre :

- une électronique de mesure avec une seule voie de mesure et un commutateur d'électrodes permettant d'interroger séquentiellement toutes les électrodes de mesure (mesures séquentielles) ;
- une ou plusieurs électroniques de mesure implémentant plusieurs voies de mesure avec chacune un commutateur d'électrodes permettant d'interroger une partie des électrodes de mesure (mesures séquentielles et parallèles ;

- autant d'électroniques de mesure ou de voies de mesure que d'électrodes de mesures, sans commutateur d'électrodes, pour interroger simultanément toutes les électrodes de mesure (mesures parallèles).

Suivant un autre aspect de la même invention, il est proposé un procédé de détection d'un objet par rapport à une surface de détection, mettant en œuvre un dispositif de détection selon l'invention.

En particulier, selon une définition générale, le procédé selon l'invention comprend :

- au moins une itération d'une première étape de détection, réalisée en appliquant aux électrodes :

  • un même potentiel alternatif, dite de garde, ou
  • des potentiels alternatifs sensiblement identiques ;

  différent(s) d'un potentiel de masse, pour déterminer une capacité, dite électrode-objet, vue par l'au moins une électrode de mesure, en fonction d'un premier signal mesuré représentatif d'une approche et d'un contact dudit objet avec ladite surface de détection ;
  caractérisé en ce qu'il comprend en outre

- au moins une itération d'une deuxième étape de détection comprenant les opérations suivantes :

  - appliquer à l'au moins une deuxième électrode :

    ▪ un deuxième potentiel proportionnel au potentiel de garde et d'amplitude différente, ou
    ▪ le potentiel de masse ; et

  - déterminer une capacité, dite totale, vue par l'au moins une électrode de mesure en fonction d'un deuxième signal mesuré représentatif d'un appui, d'une force ou d'une pression, exercé(e) par ledit objet sur ladite surface de détection.

Le procédé selon l'invention peut en outre comprendre, en termes d'étapes ou d'opération, les fonctions mises en œuvre par le dispositif selon l'invention, suivant les caractéristiques décrites plus haut, dans chacun(e) des versions/modes/exemples de réalisation.

En particulier, la deuxième étape de détection peut en outre comprendre un calcul d'une capacité, dite inter-électrodes, entre ladite électrode de mesure et ladite deuxième électrode en fonction de la capacité totale et de la capacité électrode-objet.

Suivant des modes de mise en œuvre, la deuxième étape de détection peut être déclenchée lorsque la capacité électrode-objet atteint une capacité seuil prédéterminée, ou est dans une gamme de capacités seuil prédéterminées, représentative d'un contact entre un objet et la surface de détection.

Lorsque le dispositif de détection comprend une pluralité d'électrodes de mesures équipant la surface de détection, la deuxième étape de détection peut avantageusement être réalisée uniquement dans une zone de la surface de détection dans laquelle l'objet a été détecté lors de la première étape de détection.

Ainsi, il n'est pas nécessaire de scruter toute la surface de détection lors de la deuxième étape de détection.

Lorsque le dispositif de détection comprend une pluralité d'électrodes de mesure, la capacité seuil peut être identique pour au moins deux, en particulier toutes les, électrodes de mesures.

Alternativement, ou en plus, lorsque le dispositif de détection comprend une pluralité d'électrodes de mesure, les capacités seuil utilisées pour au moins deux électrodes peuvent être différentes.

Le procédé selon l'invention peut en outre comprendre une étape, dite de calibration, comprenant une mesure et une mémorisation d'une capacité seuil.

Une telle étape de calibration peut être réalisée par exemple :

- lors de la fabrication du dispositif de détection, en usine ;
- lors de l'utilisation du dispositif, au cours d'une procédure de calibration spécifique ;
- lors de l'utilisation du dispositif, périodiquement lors de l'exécution de mesures.

Le procédé selon l'invention peut notamment comprendre une étape de calibration avec une détermination d'une capacité seuil prenant en compte au moins l'un des éléments suivants : un historique de mesures, un environnement de mesure.

Ainsi, la capacité seuil peut notamment être mise à jour en utilisant des mesures ou un historique de mesures de capacité électrode-objet obtenues en présence d'un objet en contact ou en appui sur la surface de détection. La présence de l'objet peut être requise, par exemple au cours d'une procédure spécifique de calibrage, ou déterminée automatiquement à partir des mesures de capacité totales.

En présence de plusieurs électrodes de mesure, la capacité seuil peut également être déterminée (et adaptée) en fonction de l'environnement de mesure détecté. Il est possible par exemple de détecter avec plusieurs électrodes la taille d'un objet en approche et d'adapter la valeur de la capacité de seuil en fonction de cette taille, par exemple pour prendre en compte le fait qu'un objet en contact recouvre totalement ou non une électrode de mesure.

Suivant des modes de mise en œuvre, le procédé selon l'invention peut en outre comprendre une étape, dite de test, réalisée en l'absence de l'objet, pour vérifier le fonctionnement du dispositif et comprenant les opérations suivantes :

- appliquer à l'au moins une électrode de mesure le potentiel de garde ;
- appliquer à l'au moins une seconde électrode un deuxième potentiel proportionnel au potentiel de garde et d'amplitude différente, ou le potentiel de masse ; et
- déterminer une capacité, dite capacité électrode-test, entre lesdites électrode de mesure et seconde électrode par mesure d'un troisième signal ;
- comparer ladite capacité électrode-test à une deuxième capacité seuil prédéterminée.

Cette étape de test a pour but de vérifier le fonctionnement du dispositif.

L'objet détecté, également appelé objet de commande dans la présente demande, peut être par exemple une main, portant ou non un gant, toute autre partie de corps humain, un stylet, par exemple réalisé en plastique ou en métal.

L'objet détecté peut être également tout objet de l'environnement du dispositif de détection, tel qu'un outil, une paroi ....

Suivant encore un autre aspect de l'invention, il est proposé une couche de détection, pour un équipement, comprenant un dispositif de détection selon l'invention.

Le dispositif selon l'invention, en particulier les électrodes, peu(ven)t être intégré(es) dans la couche de détection.

L'équipement peut notamment comprendre un appareil ou un appareil électronique, tel que par exemple une pièce de robot ou un robot.

La couche de détection peut être disposée sur, ou intégrée dans, une surface ou une coque de l'appareil.

La couche de détection peut alternativement se présenter sous la forme d'un élément d'habillage, tel qu'un textile d'habillage, indépendant dudit appareil.

La couche de détection peut aussi se présenter sous la forme d'une peau (ou « peau sensitive ») permettant de recouvrir tout ou partie d'un robot par exemple de forme humanoïde. Cette peau peut être conçue de sorte à avoir un aspect (couleur, surface, touché...) proche de celle d'une peau humaine.

La couche de détection peut aussi se présenter sous la forme d'une pièce ou d'un élément d'habillage de forme tubulaire, apte à être disposée par exemple autour d'un membre ou d'une portion de membre d'un robot.

L'équipement peut également comprendre un équipement médical ou médicalisé, tel qu'un lit, un matelas, un siège ou un coussin de siège.

Dans ce cas, la couche de détection peut notamment être réalisée sous la forme d'un élément d'habillage tel qu'un drap ou une housse, ou faire partie intégrante de l'équipement.

Dans ce cas, le dispositif selon l'invention peut être utilisé, de manière non limitative, pour détecter la présence d'un corps ou une personne, sa position, la pression exercée (par exemple pour prévenir des escarres), ses mouvements, des paramètres physiologiques (respiration, battements cardiaques), la présence d'humidité (urine), ...

Suivant encore un autre aspect de l'invention, il est proposé un équipement équipé d'un dispositif de détection selon l'invention.

Le dispositif de détection peut être notamment agencé de sorte que la ou les électrodes de mesure et la ou les deuxièmes électrodes soient disposées sur au moins une partie de la périphérie de l'équipement.

Suivant des modes de réalisation dudit équipement :

- la ou les électrodes de mesure et la ou les deuxièmes électrodes peuvent être disposées sur, ou dans, ou sous, une surface ou une coque dudit appareil ;
- la ou les électrodes de mesure et la ou les secondes électrodes peuvent être disposées dans un élément d'habillage indépendant dudit équipement, et rapporté sur ledit équipement ;
- la ou les deuxièmes électrodes peuvent être disposées sur, ou dans, ou sous, une surface ou une coque dudit appareil ; et la ou les électrodes de mesure peuvent être disposées dans un élément d'habillage indépendant dudit équipement, et rapporté sur ledit équipement.

## Description des figures et modes de réalisation

D'autres avantages et caractéristiques apparaîtront à l'examen de la description détaillée d'exemples nullement limitatifs, et des dessins annexés sur lesquels :

- les FIGURES la-lc sont des représentations schématiques du principe électrique d'un premier exemple de réalisation non limitatif d'un dispositif selon l'invention ;
- la FIGURE 2 est une représentation schématique du principe électrique d'un deuxième exemple de réalisation non limitatif d'un dispositif selon l'invention ;
- la FIGURE 3 est une représentation schématique du principe électrique d'un troisième exemple de réalisation non limitatif d'un dispositif selon l'invention ;
- la FIGURE 4 est une représentation schématique du principe électrique d'un quatrième exemple de réalisation non limitatif d'un dispositif selon l'invention ;
- les FIGURES 5-8 sont des représentations schématiques de différentes configurations d'électrodes pouvant être mises en œuvre dans un dispositif selon l'invention ; et
- la FIGURE 9 est une représentation schématique, sous la forme d'un diagramme, d'un exemple de réalisation non limitatif d'un procédé selon l'invention.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieur. Cette sélection comprend au moins une caractéristique de préférence fonctionnelle sans détails structurels, ou avec seulement une partie des détails structurels si cette partie uniquement est suffisante pour conférer un avantage technique ou pour différencier l'invention par rapport à l'état de la technique antérieur.

En particulier toutes les variantes et tous les modes de réalisation décrits sont combinables entre eux si rien ne s'oppose à cette combinaison sur le plan technique.

Sur les figures, les éléments communs à plusieurs figures conservent la même référence.

Les FIGURES la-lc sont des représentations schématiques du principe électrique d'un premier exemple de réalisation non limitatif d'un dispositif de détection selon l'invention.

Le dispositif 100, représenté de manière schématique sur les FIGURES la-lc, est prévu pour détecter l'approche, le contact et l'appui exercé par un objet de commande 102 sur une surface de détection 104.

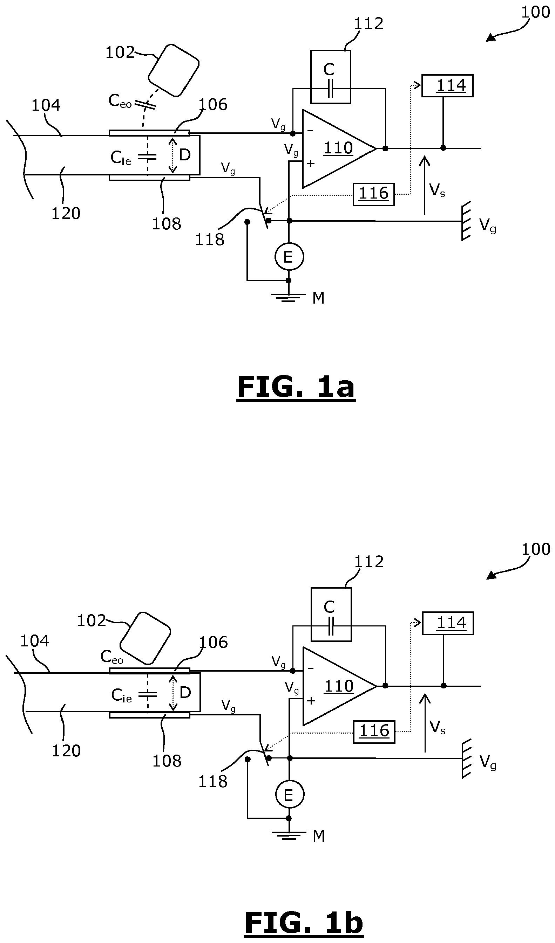

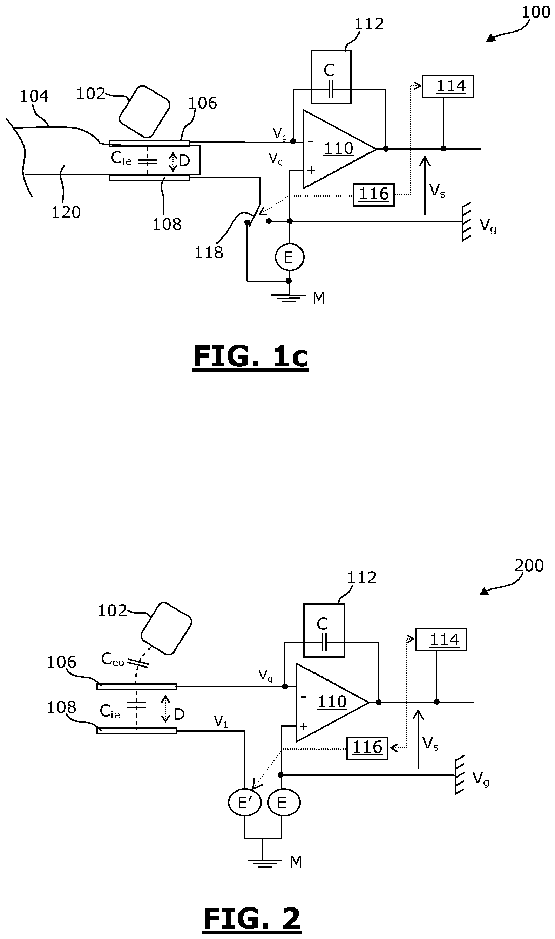

L'objet 102 est en approche et à distance de la surface de détection 104 sur la FIGURE 1a, en contact avec la surface de détection 104 sur la FIGURE 1b, et en appui sur la surface de détection sur la FIGURE 1c.

Le dispositif 100 représenté sur les FIGURES la-lc comprend au moins une électrode 106, dite de mesure, disposée selon une surface de détection 104, et une électrode 108, dite deuxième électrode, disposée face à l'électrode de mesure 106, en dessous et à distance de l'électrode de mesure 106.

Dans les modes de réalisation présentés, la surface de détection 104 est matérialisée par une face de la ou des électrodes de mesure 106, de préférence recouverte d'une couche mince de matériau isolant à l'électricité (polyimide, vernis isolant, ...) pour éviter les court-circuit avec l'objet de commande 102.

Le dispositif 100 comprend en outre un circuit électronique qui peut être représenté sous la forme d'un amplificateur opérationnel (AO) 110, dont la sortie est bouclée sur son entrée négative par une impédance 112, qui peut être par exemple : un condensateur, un condensateur associé à une résistance, ou un condensateur associé à un commutateur de remise à zéro ou de décharge. Dans l'exemple représenté, l'impédance 112 est formée par une capacité C.

Un module de mesure 114, numérique ou analogique, relié à la sortie de l'AO 110, permet de mesurer et démoduler la tension électrique ou le signal noté $V_s$, sur la sortie de l'AO 110.

Le dispositif 100 comprend en outre une source électrique E, dite de garde, fournissant un potentiel alternatif, dit de garde, noté $V_g$, différent d'une masse électrique, notée M.

Dans l'exemple représenté sur les FIGURES la-lc :

- l'électrode de mesure 106 est reliée à l'entrée négative de l'AO 110, et
- la source électrique E est reliée à l'entrée positive de l'AO 110.

Du fait de l'impédance et du gain en boucle ouverte très élevés de l'AO 110, on peut considérer que l'électrode de mesure 106 reliée à l'entrée négative de l'AO 110 est polarisée au même potentiel que celui présent sur l'entrée positive de l'AO 110.

Dans les modes de réalisation présentés, l'amplificateur opérationnel (AO) 110 est référencé au potentiel de garde $V_g$. Pour cela, il est alimenté par une source d'alimentation électrique (non représentée) également référencée au potentiel de garde $V_g$.

Alternativement, l'amplificateur opérationnel (AO) 110 peut être référencé au potentiel de masse, en étant alimenté par une source d'alimentation électrique (non représentée) référencée au potentiel de masse électrique M.

Il est à noter que l'objet de commande 102, par principe, est normalement polarisé au potentiel de masse M, directement ou indirectement par couplage résistif ou capacitif. Bien entendu rien n'oblige à ce que l'objet soit parfaitement polarisé à ce potentiel de masse M. Pour qu'il puisse être détecté, il faut simplement qu'il soit polarisé à un potentiel différent du potentiel de garde $V_g$.

La tension électrique $V_s$ présente sur la sortie de l'AO 110 est référencée au potentiel de garde $V_g$.

Pour obtenir une tension $V_s$ référencée au potentiel de masse général M, le module de traitement 114 peut comprendre notamment un amplificateur différentiel électriquement référencé au potentiel de masse général M. Cet amplificateur différentiel est relié en entrée respectivement à la sortie de l'AO 110 et au potentiel de garde et produit en sortie un signal image de $V_s$ référencé au potentiel de masse général M.

Le dispositif 100 comprend en outre un module de commande 116 contrôlant le fonctionnement d'un commutateur commandable 118, disposé entre la deuxième électrode 108 et la source électrique E. Le commutateur commandable 118 est disposé de sorte que :

- dans une première position, représentée sur les FIGURES la et 1b, il relie la deuxième électrode 108 au potentiel de garde $V_g$; et
- dans une deuxième position, représentée sur la FIGURE 1c, il relie la deuxième électrode 108 au potentiel de masse M.

Le commutateur commandable 118 est commandé pour passer de la première position à la deuxième position, notamment lorsque la capacité capacité $C_{eo}$, dite capacité électrode-objet, formée entre l'électrode de mesure 106 et l'objet de commande 102 atteint une capacité seuil, notée $C_s$, prédéterminée et mémorisée dans un moyen de mémorisation (non représenté), par exemple dans le module de commande 116. Cette capacité seuil $C_s$ est prédéterminée et est représentative d'un contact entre l'objet de commande 102 et la surface de détection 104, tel que représenté sur la FIGURE 1b.

L'électrode de mesure 106 est agencée de sorte que la distance D entre l'électrode de mesure 106 et la deuxième électrode 108 peut être modifiée, de manière élastique, localement, par une pression exercée par l'objet de commande 102 sur la surface de détection 104. En particulier, lorsqu'une pression est appliquée sur la surface de détection 104, l'électrode de mesure 106 se rapproche de la deuxième électrode 108, tel que représenté sur la FIGURE 1c. A cet effet, l'électrode de mesure 106 et la deuxième électrode 108 sont disposées de part et d'autre d'une couche 120, formée par un matériau diélectrique élastiquement compressible, tel que par exemple une mousse ou du silicone.

Dans ces conditions, l'approche et le contact de l'objet de commande 102 avec la surface de détection 104 sont détectés en fonction de la valeur de la capacité $C_{eo}$ formée entre l'électrode de mesure 106 et l'objet de commande 102. Lorsque la capacité $C_{eo}$ atteint la capacité seuil $C_s$, cela indique que l'objet 102 est en contact avec la surface de détection 104. Dans ce cas, la pression exercée par l'objet de commande 102 est détectée en fonction de la capacité $C_{ie}$, dite capacité inter-électrode, formée entre l'électrode de mesure 106 et l'électrode de garde 108.

Pour déterminer la capacité $C_{eo}$, représentative de l'approche et du contact de l'objet de commande 102 avec la surface de détection 104, un premier signal est mesuré périodiquement en mettant l'électrode de mesure 106 et la seconde électrode 108 au même potentiel alternatif, c'est-à-dire au potentiel de garde $V_g$ fourni par la source E (FIGURE la). Dans cette configuration, on a :

$$V_s = V_g \frac{C_{eo}}{C} \quad (1)$$

Cette relation (1) permet de déduire la valeur de la capacité électrode-objet $C_{eo}$ à partir du premier signal $V_s$ mesuré.

Il est à noter que dans cette configuration, la seconde électrode 108 se comporte comme une électrode de garde qui empêche l'apparition de capacités de couplage parasites ou de fuite avec l'électrode de mesure 106.

Tant que l'objet de commande 102 est à distance de la surface de détection 104, on peut se limiter à la mesure de la capacité électrode-objet $C_{eo}$.

Lorsque l'objet de commande 102 arrive en contact avec la surface de détection 104, ou à proximité immédiate de cette surface (quasi-contact), il est nécessaire de mesurer également la capacité inter-électrode $C_{ie}$, représentative de l'appui de l'objet de commande 102 sur la surface de détection 104. Cette capacité inter-électrode $C_{ie}$ est déterminée de la manière suivante.

Le contact entre l'objet de commande 102 et la surface de détection 104 est déterminé lorsque la capacité $C_{eo}$ atteint une valeur seuil prédéterminée $C_s$ (ou une gamme de capacités de seuil) (FIGURE 1b). A ce moment-là, le commutateur commandable 118 est basculé de sorte à relier l'électrode de garde 108 au potentiel de masse M, tel que montré à la FIGURE 1c. Dans cette configuration, un deuxième signal $V_s$ est mesuré en sortie de l'AO 110. Ce deuxième signal $V_s$ est représentatif d'une capacité $C_T$, dite totale, vue par l'électrode de mesure 106, de sorte que :

$$V_s = V_g \frac{C_T}{C} \ (2)$$

Cette relation (2) permet de déduire la valeur de la capacité totale $C_T$ à partir du deuxième signal $V_s$ mesuré.

Or, la capacité totale $C_T$ correspond à la somme :

- de la capacité électrode-objet $C_{eo}$, et
- de la capacité inter-électrodes $C_{ie}$ qui apparaît entre l'électrode de mesure 106 et la seconde électrode 108 du fait de leur différence de potentiel.

L'objet 102 étant au contact de la surface de commande 104, la capacité électrode-objet $C_{eo}$ ne varie plus et est toujours égale à (ou proche de) la capacité $C_s$. Par conséquent, la valeur de la capacité inter-électrodes $C_{ie}$, représentative de l'appui de l'objet 102 sur la surface de détection 104 est obtenue par soustraction, suivant la relation suivante :

$$C_{ie} = C_T - C_s \ (3),$$

ou

$$C_{ie} = C_T - C_{eoT} \ (4),$$

Avec $C_{eoT}$ étant la capacité électrode objet mesurée avec l'objet en contact.

Dans cette configuration, il faut vérifier périodiquement si l'objet de commande 102 est toujours en contact avec la surface de détection 104. Pour cela, le commutateur commandable 118 est basculé périodiquement de sorte à relier l'électrode de garde 108 au potentiel de garde $V_g$ pour mesurer la capacité électrode-objet $C_{eo}$, puis à la masse M pour mesurer la capacité totale $C_T$, et donc la capacité inter-électrodes $C_{ie}$. Ces mesures séquentielles de $C_{eo}$ et $C_T$ sont réalisées tant que la capacité électrode-objet est supérieure à la capacité de seuil ($C_{eo} \geq C_s$).

En utilisant par exemple la loi du condensateur plan, on peut relier la capacité électrode-objet $C_{eo}$ et la capacité inter-électrodes $C_{ie}$ respectivement à une distance entre l'électrode de mesure et l'objet, et à une distance D entre l'électrode de mesure et la seconde électrode. La pression peut alors être calculée à partie de la variation d'épaisseur D mesurée du matériau diélectrique 120, et de son module d'élasticité.

La détermination de chacune de ces capacités à partir des signaux mesurés peut être réalisée par le module de mesure 114, ou par le module de commande, ou encore par un ou plusieurs module(s) de calcul additionnels(s) (non représentés).

Pour cela, on peut mettre en œuvre un démodulateur synchrone qui réalisent des fonctions de multiplication du signal $V_s$ issu de l'AO 110 avec un signal de porteuse correspondant au potentiel de garde $V_g$, puis de filtrage passe-bas.

On peut également utiliser un démodulateur asynchrone comprenant un redressement suivi d'un filtre passe-bas.

La FIGURE 2 est une représentation schématique allégée du principe électrique d'un deuxième exemple de réalisation d'un dispositif selon l'invention.

Le dispositif 200, représenté sur la FIGURE 2, comprend tous les éléments du dispositif 100 des FIGURES la-lc.

A la différence du dispositif 100, le dispositif 200 ne comprend pas le commutateur commandable et comprend une deuxième source E' disposée entre la deuxième électrode 108 et le potentiel de masse M.

La deuxième source E' est commandée par le module de commande 116 de sorte que :

- la deuxième source E' fournit un potentiel V1 identique ou sensiblement identique au potentiel de garde $V_g$ lors de la mesure du premier signal : dans ce cas la seconde électrode 108 est polarisée (comme l'électrode de mesure 106) au potentiel de garde $V_g$; et
- la deuxième source E' fournit un deuxième potentiel V1 proportionnel et d'amplitude inférieure au potentiel de garde $V_g$ (V1 = $kV_g$ avec k <1) lors de la mesure du deuxième signal : dans ce cas la seconde électrode 108 est polarisée au potentiel V1 et l'électrode de mesure 106 est polarisée au potentiel de garde $V_g$.

Comme précédemment, la deuxième source E' est commandée pour fournir le potentiel de garde $V_g$ tant que la capacité $C_{eo}$ est inférieure à la capacité seuil $C_s$, puis lorsque la capacité $C_{eo}$ atteint la capacité seuil $C_s$, elle est commandée pour fournir alternativement le deuxième potentiel V1 = $kV_g$ et le potentiel de garde $V_g$.

En pratique la source E et la deuxième source E' sont générés à partir d'un même oscillateur ou d'un même générateur de fonctions pour produire des signaux de forme identique, en phase, et qui ne diffèrent que par leur amplitude.

L'utilisation d'un deuxième potentiel présente l'avantage de permettre un ajustage du gain de la détection pour pouvoir détecter la capacité électrode-objet $C_{eo}$ et la capacité totale $C_T$ dans des conditions optimales. En effet, du fait des rapports des surfaces en présence, la capacité inter-électrodes $C_{ie}$ et donc la capacité totale $C_T$ peuvent être de plusieurs ordres de grandeur supérieures à la capacité électrode-objet $C_{eo}$.

En utilisant le deuxième potentiel V1 = $kV_g$ les signaux mesurés comme indiqué précédemment deviennent respectivement :

$$V_s = V_g \frac{C_{eo}}{C} \ (5)$$

et

$$V_s = \frac{V_g}{C}(C_{eo} + (1-k)C_{eg}) = \frac{V_g}{C}(C_T - kC_{eg}) \ (6)$$

On peut donc optimiser le gain de la détection pour détecter les capacité électrode-objet $C_{eo}$ correspondant à des objets éloignés, et détecter les capacités totales $C_T$ sans saturation grâce à l'atténuation d'un facteur (1-k) obtenue.

Alternativement, la deuxième source E' peut être commandée par le module de commande 116 de sorte à, soit fournir le potentiel de garde $V_g$, soit être éteinte de sorte que la seconde électrode soir polarisée au potentiel de masse M. Dans ce cas, dans le dispositif 200 de la FIGURE 2, il est aussi possible d'ajouter un commutateur commandable entre l'électrode de garde 106 et la deuxième source E', pour éviter d'éteindre et d'allumer la deuxième source E', un tel commutateur commandable reliant la seconde électrode 108 :

- à la deuxième source E' pour la mesure du premier signal ; et
- au potentiel de masse M pour la mesure du deuxième signal.

Bien entendu, dans tous les modes de réalisation présentée, la mesure de la capacité totale $C_T$ peut être réalisée selon d'autres critères que selon une détection de la condition selon laquelle la capacité électrode-objet $C_{eo}$ atteint la capacité seuil $C_s$.

En particulier, on peut mesurer périodiquement et séquentiellement la capacité électrode-objet $C_{eo}$ et la capacité totale $C_T$ tel que décrit précédemment, de la même manière et sans tenir compte du fait que l'objet de commande 102 est en contact ou non avec la surface de détection 104.

On peut également effectuer périodiquement une vérification du bon fonctionnement du système. Pour cela :

- en l'absence d'objets 102 (ou du moins lorsque les valeurs mesurées de capacité électrode-objet $C_{eo}$ sont suffisamment faibles pour correspondre à une absence d'objets), on effectue une mesure de capacité totale $C_T$ qui dans ces conditions doit correspondre à une mesure de la capacité inter-électrodes $C_{ie}$ ;
- on compare la valeur obtenu de capacité inter-électrodes $C_{ie}$ à une valeur ou une gamme de valeurs de capacités inter-électrodes attendues, et si la différence ne satisfait pas un critère pré-établi on peut considérer que le système est défaillant et déclencher une alarme.

On peut aussi calibrer les mesures de capacité inter-électrodes pour, par exemple, tenir compte du vieillissement ou des déformations non réversibles du matériau diélectrique 120, et ainsi produire des mesures de pression ou de force plus précises. Pour cela :

- en l'absence d'objets 102 en contact avec la surface de détection 104 (ou du moins lorsque les valeurs mesurées de capacité électrode-objet $C_{eo}$ sont suffisamment faibles pour correspondre à un objet à distance de la surface de détection ou une absence d'objets), on effectue une mesure de capacité totale $C_T$ qui dans ces conditions doit correspondre à une mesure de la capacité inter-électrodes $C_{ie}$ ;
- On utilise cette mesure de capacité inter-électrodes $C_{ie}$ comme valeur de référence « à vide » ou sans enfoncement, et/ou on en déduit une épaisseur de diélectrique 120 nominale (c'est-à-dire sans contrainte appliquée).

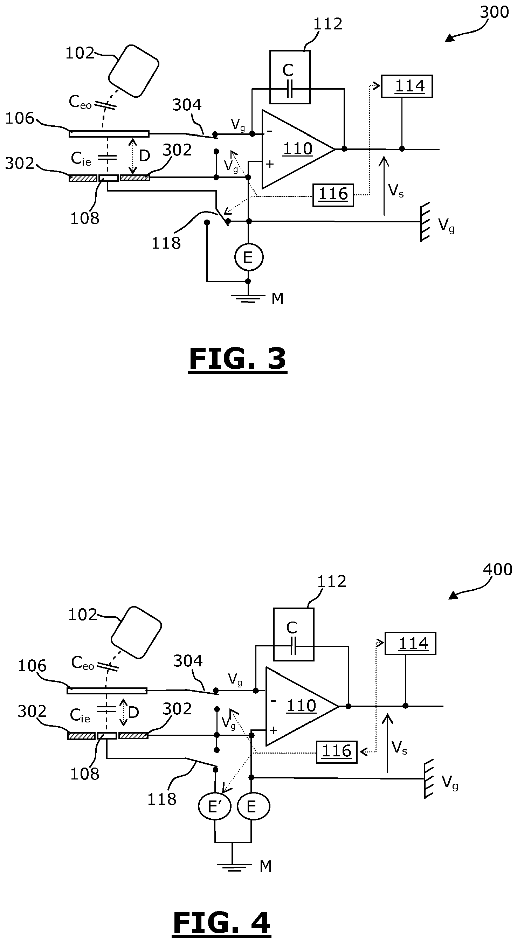

La FIGURE 3 est une représentation schématique allégée du principe électrique d'un troisième exemple de réalisation d'un dispositif selon l'invention.

Le dispositif 300, représenté sur la FIGURE 3, comprend tous les éléments du dispositif 100 des FIGURES la-lc.

A la différence du dispositif 100, le dispositif 300 comprend, en plus de l'électrode de mesure 106 et de la deuxième électrode 108, des électrodes de garde additionnelles 302.

Ces électrodes de garde additionnelles 302 sont polarisées au potentiel de garde $V_g$, comme les électrodes de mesure 106, et servent donc de garde active pour éliminer les capacités de couplage parasites ou de fuite avec l'environnement. Pour cela, elles peuvent être reliées à l'entrée positive de l'AO 110, comme illustré. En particulier, les électrodes de garde additionnelles 302 peuvent être réalisées sous la forme d'un plan de garde additionnel ajourée avec les deuxièmes électrodes 108 disposées dans des ouvertures de ce plan de garde additionnel 302.

Ainsi, pour la mesure du premier signal, toutes les électrodes 106, 108 et 302 sont polarisées au potentiel de garde $V_g$. Pour la mesure du deuxième signal, l'électrode de mesure 106 et l'électrode garde additionnelle 302 sont maintenues au potentiel de garde $V_g$, et la deuxième électrode 108 est mise au potentiel de masse M, par le commutateur 118 commandé par le module de commande 116.

Le dispositif 300 est en outre agencé pour permettre de gérer une pluralité d'électrodes de mesure 106, séquentiellement, avec une même électronique de détection (et en particulier un même AO 110). Pour cela, il comprend un commutateur d'électrodes 304 qui permet de relier sélectivement les électrodes de mesure 106, soit à l'entrée négative de l'AO 110 pour effectuer des mesures (électrode de mesure 106 active), soit au potentiel de garde $V_g$ par exemple à l'entrée positive de l'AO 110. Le commutateur d'électrodes 304 est en outre agencé de sorte que lorsqu'une électrode de mesure 106 est reliée à l'entrée de l'AO 110, donc active, les autres électrodes de mesure 106 sont polarisées au potentiel de garde $V_g$ et contribuent aux éléments de garde.

Dans une configuration avec une pluralité d'électrodes de mesure 106, le commutateur 118 qui contrôle le potentiel de la deuxième électrode peut être configuré de différentes manières.

Pour la mesure du premier signal, toutes les deuxièmes électrodes 108 sont polarisées au potentiel de garde $V_g$.

Pour la mesure du deuxième signal, le commutateur 118 peut être configuré de sorte à :

- soit relier toutes les deuxièmes électrodes 108 au potentiel de masse M ;
- soit relier la deuxième électrode 108 faisant face à l'électrode de mesure 106 active (reliée à l'entrée négative de l'AO 110) au potentiel de masse M et relier toutes les autres deuxièmes électrodes 108 au potentiel de garde $V_g$ pour qu'elles contribuent aux éléments de garde.

Bien entendu, des exemples de réalisation alternatifs peuvent être obtenus en combinant l'exemple de réalisation de la FIGURE 3 avec celui de la FIGURE 2, c'est-à-dire en utilisant une deuxième source E' pour polariser les secondes électrodes 108 à un deuxième potentiel pour la mesure du deuxième signal, comme décrit précédemment.

La FIGURE 4 est une représentation schématique allégée du principe électrique d'un tel exemple de réalisation alternatif.

Pour gérer une pluralité d'électrodes 106, on peut mettre en œuvre un commutateur d'électrodes 304 comme décrit précédemment.

On peut également mettre en œuvre un commutateur 118 pour commuter le potentiel de la ou des deuxièmes électrodes 108, soit au potentiel de garde $V_g$, soit au deuxième potentiel tel que généré par la deuxième source E'.

Comme précédemment, pour la mesure du deuxième signal, le commutateur 118 peut alors être configuré de sorte à :

- soit relier toutes les deuxièmes électrodes 108 au deuxième potentiel de la deuxième source E' ;
- soit relier la deuxième électrode 108 faisant face à l'électrode de mesure 106 active (reliée à l'entrée négative de l'AO 110) au deuxième potentiel et relier toutes les autres deuxièmes électrodes 108 au potentiel de garde $V_g$ pour qu'elles contribuent aux éléments de garde.

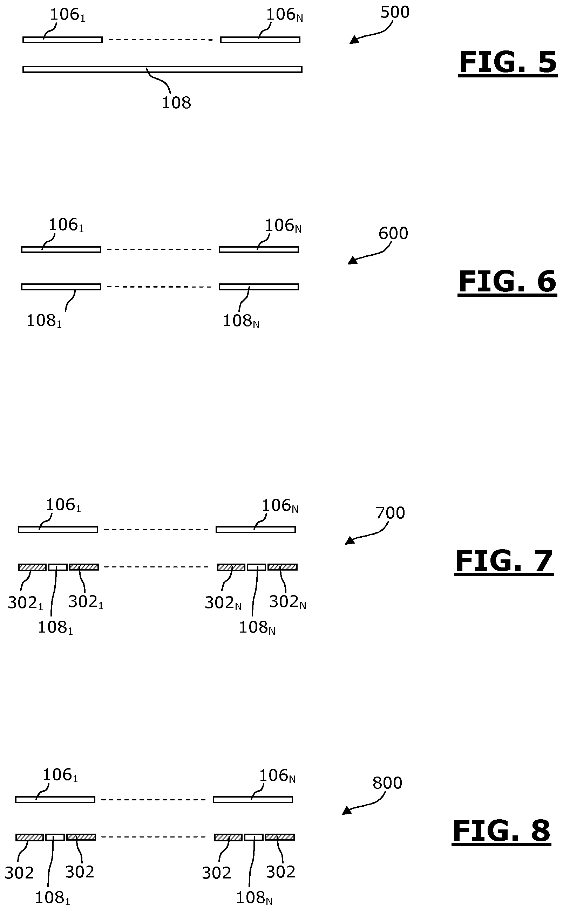

La FIGURE 5 est une représentation schématique d'une première configuration d'électrodes pouvant être mise en œuvre dans un dispositif selon l'invention.

Dans la configuration 500, représentée sur la FIGURE 5, le dispositif peut comprendre une pluralité d'électrodes de mesure $106_1$-$106_N$, et une unique seconde électrode 108 commune à toutes les électrodes de mesure $106_1$-$106_N$.

La FIGURE 6 est une représentation schématique d'une deuxième configuration d'électrodes pouvant être mise en œuvre dans un dispositif selon l'invention.

Dans la configuration 600, représentée sur la FIGURE 8, le dispositif peut comprendre une pluralité d'électrodes de mesure $106_1$-$106_N$ et une deuxième électrode individuelle, respectivement $108_1$-$108_N$, pour chaque électrode de mesure $106_1$-$106_N$.

La FIGURE 7 est une représentation schématique d'une troisième configuration d'électrodes pouvant être mise en œuvre dans un dispositif selon l'invention.

Dans la configuration 700, représentée sur la FIGURE 7, le dispositif peut comprendre une pluralité d'électrodes de mesure $106_1$-$106_N$, et pour chaque électrode de mesure $106_1$-$106_N$ :

- une deuxième électrode individuelle, respectivement $108_1$-$108_N$ ; et
- une électrode de garde additionnelle ajourés individuelle, respectivement $302_1$-$302_N$.

La FIGURE 8 est une représentation schématique d'une quatrième configuration d'électrodes pouvant être mise en œuvre dans un dispositif selon l'invention.

Dans la configuration 800, représentée sur la FIGURE 8, le dispositif peut comprendre une pluralité d'électrodes de mesure $106_1$-$106_N$.

Le dispositif comprend en outre une seule et unique électrode de garde additionnelle 302, commune à l'ensemble des électrodes de mesure $106_1$-$106_N$, et formant un plan de garde.

Le dispositif comprend pour chaque électrode de mesure $106_1$-$106_N$, une deuxième électrode individuelle, respectivement $108_1$-$108_N$, incrustée dans le plan de garde formée par l'unique électrode de garde additionnelle 302.

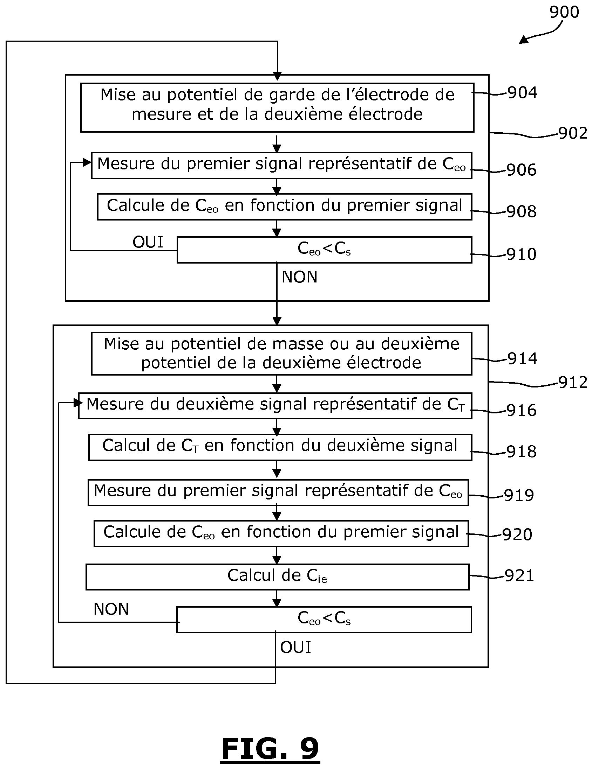

La FIGURE 9 est une représentation schématique, sous la forme d'un digramme d'un exemple de réalisation non limitatif, d'un procédé de détection selon l'invention.

Le procédé 900 comprend une ou plusieurs itérations d'une première étape de détection 902, réalisée(s) lorsqu'un objet de commande s'approche de la surface de détection.

Cette première étape de détection 902 comprend une étape 904 de mise au potentiel de garde de l'électrode de mesure et de la deuxième électrode qui peut être une électrode garde ou une électrode de test, comme décrit plus haut.

Puis, une étape 906 mesure un premier signal représentatif de la capacité électrode-objet $C_{eo}$.

En fonction du signal mesuré, la capacité $C_{eo}$ est calculée lors d'une étape 908.

Lors d'une étape 910, la capacité $C_{eo}$ mesurée est comparée à une capacité seuil $C_s$ prédéterminée, représentant une capacité électrode-objet obtenue lorsqu'il y a contact entre l'objet de commande et la surface de détection.

Si la capacité $C_{eo}<C_s$ alors l'étape 904 est réitérée, par exemple à une fréquence prédéterminée.

Si la capacité $C_{eo}\geq C_s$ alors l'étape 904 est suivie d'une deuxième étape de détection 912.

Cette deuxième étape de détection 912 comprend une étape 914 de mise au potentiel de masse ou au deuxième potentiel de la deuxième électrode. L'électrode de mesure est conservée au potentiel de garde.

Puis, une étape 916 réalise une mesure d'un deuxième signal représentatif de la capacité totale $C_T$ vue par l'électrode de mesure.

En fonction du deuxième signal mesuré, la capacité $C_T$ est calculée lors d'une étape 918.

Puis, une étape 919 mesure un premier signal représentatif de la capacité électrode-objet $C_{eo}$.

En fonction du signal mesuré, la capacité $C_{eo}$ est calculée lors d'une étape 920.

Lors d'une étape 921, la capacité inter-électrodes $C_{ie}$, représentative de l'appui de l'objet de commande sur la surface de détection, est calculée en retranchant à la capacité $C_T$ calculée, la capacité seuil $C_s$.

Tant que la capacité $C_{eo}\geq C_s$ alors l'étape 912 est réitérée. Sinon, le procédé 900 reprend à l'étape 902.

Il est à noter que les étapes de mesures de la capacité $C_{eo}$ pour la détermination de la capacité inter-électrodes $C_{ie}$ peuvent ne pas être réalisées à toutes les itérations de la deuxième étape de détection 912, mais plus rarement, et la capacité $C_{eo}$ mémorisée.

Bien sûr, l'invention n'est pas limitée aux exemples qui viennent d'être décrits et de nombreux aménagements peuvent être apportés à ces exemples sans sortir du cadre de l'invention.

**Revendications**

1. Dispositif (100;200;300;400) de détection d'un objet (102) par rapport à une surface de détection (104), comprenant :

   - au moins une électrode (106), dite de mesure, et
   - au moins une deuxième électrode (108), disposée face à ladite électrode de mesure (106) ;

   lesdites électrodes (106,108) sont séparées d'une distance (D) élastiquement modifiable localement, par une pression exercée par ledit objet (102) sur ladite surface de détection (104) ;
   ledit dispositif comprenant au moins un moyen de commande (116) agencé pour appliquer auxdites électrodes (106,108) :

   - un même potentiel alternatif ($V_g$), dit de garde, ou
   - des potentiels alternatifs sensiblement identiques ;

différent(s) d'un potentiel de masse (M), de sorte à mesurer un premier signal électrique relatif à une capacité ($C_{eo}$), dite électrode-objet, entre ladite électrode de mesure (106) et ledit objet (102), représentatif d'une approche et d'un contact dudit objet (102) avec ladite surface de détection (104) ; **caractérisé en ce que** ledit moyen de commande (116) est en outre agencé pour appliquer à ladite deuxième électrode (108) :

- un deuxième potentiel proportionnel au potentiel de garde ($V_g$) et d'amplitude différente, ou
- le potentiel de masse (M),

de sorte à mesurer un deuxième signal électrique relatif à la capacité, dite totale, vue par ladite électrode de mesure (106), représentatif d'un appui, d'une force ou d'une pression, exercé(e) par ledit objet (102) sur ladite surface de détection (104).

2. Dispositif (100;200;300;400) selon l'une quelconque des revendications précédentes, **caractérisé en ce qu'**il comprend au moins un module de calcul (114) configuré pour calculer une capacité ($C_{ie}$), dite inter-électrodes, entre ladite électrode de mesure (106) et ladite deuxième électrode (108), en fonction de ladite capacité totale et de ladite capacité électrode-objet ($C_{eo}$).

3. Dispositif (100;200;300;400) selon l'une quelconque des revendications précédentes, **caractérisé en ce qu'**il comprend un module de calcul configuré pour :

- déterminer une distance ou un contact entre l'objet (102) et la surface de détection (104) en fonction du premier signal ; et/ou
- déterminer une pression, une force ou un appui appliqué par ledit objet (102) sur la surface de détection (104) en fonction du deuxième signal.

4. Dispositif (100;200;300;400) selon l'une quelconque des revendications précédentes, **caractérisé en ce que** l'électrode de mesure (106) et la deuxième électrode (108) sont séparées par une couche (120) élastiquement compressible comprenant, ou formée par, un matériau diélectrique.

5. Dispositif (100;200;300;400) selon l'une quelconque des revendications précédentes, **caractérisé en ce que** l'électrode de mesure (106) est disposée sur, ou dans, ou sous, un support, réalisé en un matériau souple, tel qu'un tissu, placé au-dessus et à distance de la deuxième électrode (108), et se déformant au moins localement lorsqu'une pression est exercée sur ledit support.

6. Dispositif (100;200;300;400) selon l'une quelconque des revendications précédentes, **caractérisé en ce qu'**il comprend plusieurs électrodes de mesure ($106_1$-$106_N$).

7. Dispositif (100;200;300;400) selon la revendication 6, **caractérisé en ce qu'**il comprend une ou des deuxièmes électrodes (108) agencées selon l'une au moins des configurations suivantes :

- au moins une deuxième électrode (108) disposée en regard de plusieurs, en particulier de toutes les, électrodes de mesure ($106_1$-$106_N$) ;
- pour au moins une, en particulier chaque, électrode de mesure ($106_1$-$106_N$), une deuxième électrode ($108_1$-$108_N$) disposée en regard de ladite électrode de mesure ($106_1$-$106_N$) ;
- pour au moins une, en particulier chaque, électrode de mesure ($106_1$-$106_N$), plusieurs deuxièmes électrodes ($108_1$-$108_N$) disposées en regard de ladite électrode de mesure ($106_1$-$106_N$).

8. Dispositif (100;200;300;400) selon l'une quelconque des revendications précédentes, **caractérisé en ce qu'**il comprend :

- une matrice d'électrodes de mesure ($106_1$-$106_N$), organisée en lignes-colonnes ; et
- en regard de chaque ligne, respectivement chaque colonne, d'électrodes de mesure ($106_1$-$106_N$), au moins une ligne, respectivement une colonne, constituée d'une ou plusieurs deuxième(s) électrode(s) ($108_1$-$108_N$);

la ou les deuxième(s) électrode(s) d'une même ligne, respectivement d'une même colonne, étant au même potentiel.

9. Couche de détection, pour un équipement, comprenant un dispositif de détection (100;200;300;400) selon l'une quelconque des revendications 1 à 8.

**10.** Equipement équipé d'un dispositif de détection (100;200;300;400) selon l'une quelconque des revendications 1 à 8.

**11.** Procédé (900) de détection d'un objet (102) par rapport à une surface de détection (104), avec un dispositif de détection (100;200;300;400) selon l'une quelconque des revendications précédentes, ledit procédé (900) comprenant au moins une itération d'une première étape de détection (902), réalisée en appliquant aux électrodes (106;108) :

- un même potentiel alternatif ($V_g$), dite de garde, ou
- des potentiels alternatifs sensiblement identiques ;

différent(s) d'un potentiel de masse (M), pour déterminer une capacité ($C_{eo}$), dite électrode-objet, vue par l'au moins une électrode de mesure (106), en fonction d'un premier signal mesuré représentatif d'une approche et d'un contact dudit objet (102) avec ladite surface de détection (104) ;
**caractérisé en ce qu'**il comprend en outre au moins une itération d'une deuxième étape de détection (912), comprenant les opérations suivantes :

- appliquer à l'au moins une deuxième électrode (108) :

• un deuxième potentiel proportionnel au potentiel de garde ($V_g$) et d'amplitude différente, ou
• le potentiel de masse (M) ; et

- déterminer une capacité, dite totale, vue par l'au moins une électrode de mesure (106), en fonction d'un deuxième signal mesuré représentatif d'un appui, d'une force ou d'une pression, exercé(e) par ledit objet (102) sur ladite surface de détection (104).

**12.** Procédé (900) selon la revendication 11, **caractérisé en ce que** la deuxième étape de détection (912) comprend en outre une étape de calcul (921) d'une capacité ($C_{ie}$), dite inter-électrodes, entre ladite électrode de mesure (106) et ladite deuxième électrode (108) en fonction de la capacité totale et de la capacité électrode-objet ($C_{eo}$).

**13.** Procédé (900) selon l'une quelconque des revendications 11 ou 12, **caractérisé en ce que** la deuxième étape de détection (912) est déclenchée lorsque la capacité électrode-objet ($C_{eo}$) atteint une capacité seuil prédéterminée, ou est dans une gamme de capacités seuil prédéterminée, représentative d'un contact entre un objet (102) et la surface de détection (104).

**14.** Procédé (900) selon la revendication 13, **caractérisé en ce que**, le dispositif de détection (100;200;300;400) comprend une pluralité d'électrodes de mesure ($106_1$-$106_N$) équipant la surface de détection (104), la deuxième étape de détection (912) étant réalisée uniquement dans une zone de la surface de détection (104) dans laquelle l'objet (102) a été détecté lors de la première étape de détection (902).

**15.** Procédé selon l'une quelconque des revendications 13 ou 14, **caractérisé en ce qu'**il comprend une étape, dite de calibration, comprenant une mesure et une mémorisation d'une capacité seuil.

**16.** Procédé selon la revendication 15 **caractérisé en ce que** l'étape de calibration comprend une détermination d'une capacité seuil prenant en compte au moins l'un des éléments suivants : un historique de mesures, un environnement de mesures.

**17.** Procédé (900) selon l'une quelconque des revendications 11 à 16, **caractérisé en ce qu'**il comprend en outre une étape, dite de test, réalisée en l'absence de l'objet pour vérifier le fonctionnement du dispositif, et comprenant les opérations suivantes :

- appliquer à l'au moins une électrode de mesure le potentiel de garde ($V_g$) ;
- appliquer à l'au moins une seconde électrode un deuxième potentiel entre le potentiel de garde ($V_g$) et le potentiel de masse (M), ou le potentiel de masse (M); et
- déterminer une capacité, dite capacité électrode-test, entre lesdites électrode de mesure et seconde électrodes par mesure d'un troisième signal ;
- comparer ladite capacité électrode-test à une deuxième capacité seuil prédéterminée.

**Patentansprüche**

1. Vorrichtung (100; 200; 300; 400) zum Erfassen eines Objekts (102) relativ zu einer Erfassungsfläche (104), umfassend:

   - wenigstens eine Elektrode (106), sogenannte Messelektrode, und
   - wenigstens eine zweite Elektrode (108), die der Messelektrode (106) zugewandt angeordnet ist;

   die Elektroden (106, 108) sind durch einen Abstand (D) getrennt, der durch einen Druck, den das Objekt (102) auf die Erfassungsfläche (104) ausübt, lokal elastisch veränderbar ist;
   wobei die Vorrichtung wenigstens ein Steuermittel (116) umfasst, das dazu eingerichtet ist, an die Elektroden (106, 108) folgendes anzulegen:

   - ein gleiches Wechselpotential ($V_g$), sogenanntes Schutzpotential, oder
   - im Wesentlichen identische Wechselpotentiale;

   das/die von einem Massepotential (M) verschieden ist/sind, um ein erstes elektrisches Signal bezüglich einer sogenannten Elektrode-Objekt-Kapazität ($C_{eo}$) zwischen der Messelektrode (106) und dem Objekt (102) zu messen, das für eine Annäherung und einen Kontakt des Objekts (102) mit der Erfassungsfläche (104) repräsentativ ist; **dadurch gekennzeichnet, dass** das Steuermittel (116) ferner dazu eingerichtet ist, an die zweite Elektrode (108) folgendes anzulegen:

   - ein zweites Potential, das zu dem Schutzpotential ($V_g$) proportional ist und eine unterschiedliche Amplitude aufweist, oder
   - das Massepotential (M),

   um ein zweites elektrisches Signal bezüglich der durch die Messelektrode (106) festgestellten sogenannten Gesamtkapazität zu messen, das für eine Auflage, eine Kraft oder einen Druck, die/der durch das Objekt (102) auf die Erfassungsfläche (104) ausgeübt wird, repräsentativ ist.

2. Vorrichtung (100; 200; 300; 400) nach einem der vorhergehenden Ansprüche, **dadurch gekennzeichnet, dass** sie wenigstens ein Berechnungsmodul (114) umfasst, das dazu ausgelegt ist, eine sogenannte Zwischen-Elektroden-Kapazität ($C_{ie}$) zwischen der Messelektrode (106) und der zweiten Elektrode (108) in Abhängigkeit von der Gesamtkapazität und der Elektrode-Objekt-Kapazität ($C_{eo}$) zu berechnen.

3. Vorrichtung (100; 200; 300; 400) nach einem der vorhergehenden Ansprüche, **dadurch gekennzeichnet, dass** sie ein Berechnungsmodul umfasst, das dazu ausgelegt ist:

   - einen Abstand oder einen Kontakt zwischen dem Objekt (102) und der Erfassungsfläche (104) in Abhängigkeit von dem ersten Signal zu bestimmen; und/oder
   - einen Druck, eine Kraft oder eine Auflage zu bestimmen, der/die von dem Objekt (102) auf die Erfassungsfläche (104) ausgeübt wird, in Abhängigkeit von dem zweiten Signal.

4. Vorrichtung (100; 200; 300; 400) nach einem der vorhergehenden Ansprüche, **dadurch gekennzeichnet, dass** die Messelektrode (106) und die zweite Elektrode (108) durch eine elastisch komprimierbare Schicht (120) getrennt sind, die ein dielektrisches Material umfasst oder daraus gebildet ist.

5. Vorrichtung (100; 200; 300; 400) nach einem der vorhergehenden Ansprüche, **dadurch gekennzeichnet, dass** die Messelektrode (106) auf oder in oder unter einem Träger angeordnet ist, welcher aus einem flexiblen Material wie einem Gewebe gefertigt ist, welches oberhalb und im Abstand von der zweiten Elektrode (108) angeordnet ist und sich zumindest lokal verformt, wenn auf den Träger ein Druck ausgeübt wird.

6. Vorrichtung (100;200; 300; 400) nach einem der vorhergehenden Ansprüche, **dadurch gekennzeichnet, dass** sie mehrere Messelektroden ($106_1$-$106_N$) umfasst.

7. Vorrichtung (100; 200; 300; 400) nach Anspruch 6, **dadurch gekennzeichnet, dass** sie eine oder mehrere zweite Elektroden (108) umfasst, die entsprechend wenigstens einer der folgenden Konfigurationen angeordnet sind:

- wenigstens eine zweite Elektrode (108), die gegenüber mehreren, insbesondere allen Messelektroden ($106_1$-$106_N$) angeordnet ist;
- für wenigstens eine, insbesondere jede Messelektrode ($106_1$-$106_N$) eine zweite Elektrode ($108_1$-$108_N$), die gegenüber der Messelektrode ($106_1$-$106_N$) angeordnet ist;
- für wenigstens eine, insbesondere jede Messelektrode ($106_1$-$106_N$) mehrere zweite Elektroden ($108_1$-$108_N$), die gegenüber der Messelektrode ($106_1$-$106_N$) angeordnet sind.

**8.** Vorrichtung (100; 200; 300; 400) nach einem der vorhergehenden Ansprüche, **dadurch gekennzeichnet, dass** sie umfasst:

- eine Matrix von Messelektroden ($106_1$-$106_N$), die in Zeilen-Spalten angeordnet sind; und
- gegenüber einer jeden Zeile bzw. jeden Spalte von Messelektroden ($106_1$-$106_N$) wenigstens eine Zeile bzw. eine Spalte, bestehend aus einer oder mehreren zweiten Elektrode(n) ($108_1$-$108_N$);

wobei die zweite(n) Elektrode(n) einer gleichen Zeile bzw. einer gleichen Spalte auf dem gleichen Potential liegt/liegen.

**9.** Erfassungsschicht für eine Einrichtung, umfassend eine Erfassungsvorrichtung (100; 200; 300; 400) nach einem der Ansprüche 1 bis 8.

**10.** Einrichtung, die mit einer Erfassungsvorrichtung (100; 200; 300; 400) nach einem der Ansprüche 1 bis 8 ausgestattet ist.

**11.** Verfahren (900) zum Erfassen eines Objekts (102) relativ zu einer Erfassungsfläche (104), mit einer Erfassungsvorrichtung (100; 200; 300; 400) nach einem der vorhergehenden Ansprüche, wobei das Verfahren (900) wenigstens eine Iteration eines ersten Erfassungsschrittes (902) umfasst, der durchgeführt wird, indem an die Elektroden (106; 108) folgendes angelegt wird:

- ein gleiches Wechselpotential ($V_g$), sogenanntes Schutzpotential, oder
- im Wesentlichen identische Wechselpotentiale;

das/die von einem Massepotential (M) verschieden ist/sind, um eine durch die wenigstens eine Messelektrode (106) festgestellte sogenannte Elektrode-Objekt-Kapazität ($C_{eo}$) in Abhängigkeit von einem ersten gemessenen Signal zu bestimmen, das für eine Annäherung und einen Kontakt des Objekts (102) mit der Erfassungsfläche (104) repräsentativ ist;

**dadurch gekennzeichnet, dass** es ferner wenigstens eine Iteration eines zweiten Erfassungsschrittes (912) umfasst, der die folgenden Vorgänge umfasst:

- Anlegen an die wenigstens eine zweite Elektrode (108):

  • eines zweiten Potentials, das zu dem Schutzpotential ($V_g$) proportional ist und eine unterschiedliche Amplitude aufweist, oder
  • das Massepotential (M), und

- Bestimmen einer durch die wenigstens eine Messelektrode (106) festgestellten sogenannten Gesamtkapazität in Abhängigkeit von einem zweiten gemessenen Signal, das für eine Auflage, eine Kraft oder einen Druck, die/der durch das Objekt (102) auf die Erfassungsfläche (104) ausgeübt wird, repräsentativ ist.

**12.** Verfahren (900) nach Anspruch 11, **dadurch gekennzeichnet, dass** der zweite Erfassungsschritt (912) ferner einen Schritt zur Berechnung (921) einer sogenannten Zwischen-Elektroden-Kapazität ($C_{ie}$) zwischen der Messelektrode (106) und der zweiten Elektrode (108) in Abhängigkeit von der Gesamtkapazität und der Elektrode-Objekt-Kapazität ($C_{eo}$) umfasst.

**13.** Verfahren (900) nach einem der Ansprüche 11 oder 12, **dadurch gekennzeichnet, dass** der zweite Erfassungsschritt (912) ausgelöst wird, wenn die Elektrode-Objekt-Kapazität ($C_{eo}$) eine vorbestimmte Schwellenkapazität erreicht oder sich in einem vorbestimmten Schwellenkapazitätsbereich befindet, die/der für einen Kontakt zwischen einem Objekt (102) und der Erfassungsfläche (104) repräsentativ ist.

**14.** Verfahren (900) nach Anspruch 13, **dadurch gekennzeichnet, dass** die Erfassungsvorrichtung (100; 200; 300; 400) mehrere Messelektroden ($106_1$-$106_N$) umfasst, mit der die Erfassungsfläche (104) ausgestattet ist, wobei der zweite Erfassungsschritt (912) lediglich in einem Bereich der Erfassungsfläche (104) durchgeführt wird, in dem das Objekt (102) während des ersten Erfassungsschrittes (902) erfasst wurde.

**15.** Verfahren nach einem der Ansprüche 13 oder 14, **dadurch gekennzeichnet, dass** es einen sogenannten Kalibrierungsschritt umfasst, der eine Messung und eine Speicherung einer Schwellenkapazität umfasst.

**16.** Verfahren nach Anspruch 15, **dadurch gekennzeichnet, dass** der Kalibrierungsschritt ein Bestimmen einer Schwellenkapazität unter Berücksichtigung von wenigstens einem der folgenden Elemente umfasst: einer Messhistorie, einer Messumgebung.

**17.** Verfahren (900) nach einem der Ansprüche 11 bis 16, **dadurch gekennzeichnet, dass** es ferner einen sogenannten Testschritt umfasst, der in Abwesenheit des Objekts durchgeführt wird, um den Betrieb der Vorrichtung zu überprüfen, und der die folgenden Vorgänge umfasst:

- Anlegen des Schutzpotentials ($V_g$) an die wenigstens eine Messelektrode;
- Anlegen eines zweiten Potentials zwischen dem Schutzpotential ($V_g$) und dem Massepotential (M) oder des Massepotentials (M) an die wenigstens eine zweite Elektrode; und
- Bestimmen einer sogenannten Elektrode-Test-Kapazität zwischen der Messelektrode und der zweiten Elektrode durch Messen eines dritten Signals;
- Vergleichen der Elektrode-Test-Kapazität mit einer vorbestimmten zweiten Schwellenkapazität.

## Claims

**1.** Device (100; 200; 300; 400) for detecting an object (102) with respect to a detection surface (104) comprising:

- at least one electrode (106), called measurement electrode, and
- at least one second electrode (108), placed facing said measurement electrode (106); said electrodes (106, 108) are separated by a distance (D) that is elastically modifiable locally, by a load exerted by said object (102) on said detection surface (104);

said device comprising at least one control means (116) arranged in order to apply to said electrodes (106, 108):

- one and the same alternating potential ($V_g$), called guard potential, or
- alternating potentials that are substantially identical;

that is(are) different from a ground potential (M), so as to measure a first electrical signal with respect to a capacitance ($C_{eo}$), called electrode-object capacitance, between said measurement electrode (106) and said object (102), representative of an approach and a contact of said object (102) with said detection surface (104); **characterized in that** said control means (116) is further arranged in order to apply to said second electrode (108):

- a second potential proportional to the guard potential ($V_g$) and having a different amplitude, or
- the ground potential (M),

so as to measure a second electrical signal with respect to the capacitance, called total capacitance, seen by said measurement electrode (106), representative of a load, a force, or a pressure, exerted by said object (102) on the detection surface (104).

**2.** Device (100; 200; 300; 400) according to any one of the preceding claims, **characterized in that** it comprises at least one calculation module (114) configured in order to calculate a capacitance ($C_{ie}$), called inter-electrode capacitance, between said measurement electrode (106) and said second electrode (108), as a function of said total capacitance and said electrode-object capacitance ($C_{eo}$).

**3.** Device (100; 200; 300; 400) according to any one of the preceding claims, **characterized in that** it comprises a calculation module configured in order to:

- determine a distance or a contact between the object (102) and the detection surface (104) as a function of the first signal; and/or
- determine a pressure, a force or a load applied by said object (102) on the detection surface (104) as a function of the second signal.

4. Device (100; 200; 300; 400) according to any one of the preceding claims, **characterized in that** the measurement electrode (106) and the second electrode (108) are separated by a layer (120) that is elastically compressible comprising, or formed by, a dielectric material.

5. Device (100; 200; 300; 400) according to any one of the preceding claims, **characterized in that** the measurement electrode (106) is placed on, or in, or under, a support, produced from a flexible material, such as a fabric, placed above and at a distance from the second electrode (108), and deforming at least locally when a load is exerted on said support.

6. Device (100; 200; 300; 400) according to any one of the preceding claims, **characterized in that** it comprises several measurement electrodes ($106_1$-$106_N$).

7. Device (100; 200; 300; 400) according to claim 6, **characterized in that** it comprises one or more second electrodes (108) arranged according to at least one of the following configurations:

   - at least one second electrode (108) placed opposite several, in particular all, the measurement electrodes ($106_1$-$106_N$);
   - for at least one, in particular each, measurement electrode ($106_1$-$106_N$), a second electrode ($108_1$-$108_N$) placed opposite said measurement electrode ($106_1$-$106_N$);
   - for at least one, in particular each, measurement electrode ($106_1$-$106_N$), several second electrodes ($108_1$-$108_N$) placed opposite said measurement electrode ($106_1$-$106_N$).

8. Device (100; 200; 300; 400) according to any one of the preceding claims, **characterized in that** it comprises:

   - an array of measurement electrodes ($106_1$-$106_N$), organized in rows and columns; and
   - opposite each row, respectively each column, measurement electrodes ($106_1$-$106_N$), at least one row, respectively one column, constituted by one or more second electrode(s) ($108_1$-$108_N$);

   the second electrode(s) of one and the same row, respectively one and the same column, being at the same potential.

9. Detection layer, for an item of equipment, comprising a detection device (100; 200; 300; 400) according to any one of claims 1 to 8.

10. Item of equipment equipped with a detection device (100; 200; 300; 400) according to any one of claims 1 to 8.

11. Method (900) for detecting an object (102) with respect to a detection surface (104) with a detection device (100; 200; 300; 400) according to any one of the preceding claims, said method (900) comprising at least one iteration of a first detection step (902), carried out by applying to the electrodes (106; 108):

   - one and the same alternating potential ($V_g$), called guard potential, or
   - alternating potentials that are substantially identical;

   that is(are) different to a ground potential (M), in order to determine a capacitance ($C_{eo}$), called electrode-object capacitance, seen by the at least one measurement electrode (106) as a function of a measured first signal representative of an approach and a contact of said object (102) with said detection surface (104);
   **characterized in that** it also comprises at least one iteration of a second detection step (912), comprising the following operations:

   - applying to the at least one second electrode (108):

     • a second potential proportional to the guard potential ($V_g$) and having a different amplitude, or
     • the ground potential (M); and

- determining a capacitance, called total capacitance, seen by the at least one measurement electrode (106) as a function of a measured second signal representative of a load, a force, or a pressure, exerted by said object (102) on said detection surface (104).

12. Method (900) according to claim 11, **characterized in that** the second detection step (912) also comprises a step of calculating (921) a capacitance ($C_{ie}$), called inter-electrode capacitance, between said measurement electrode (106) and said second electrode (108) as a function of the total capacitance and of the electrode-object capacitance ($C_{eo}$).

13. Method (900) according to any one of claims 11 or 12, **characterized in that** the second detection step (912) is initiated when the electrode-object capacitance ($C_{eo}$) reaches a predetermined threshold capacitance, or is within a predetermined range of threshold capacitances, representative of a contact between an object (102) and the detection surface (104).

14. Method (900) according to claim 13, **characterized in that** the detection device (100; 200; 300; 400) comprises a plurality of measurement electrodes ($106_1$-$106_N$) equipping the detection surface (104), the second detection step (912) being carried out only in an area of the detection surface (104) in which the object (102) was detected during the first detection step (902).

15. Method according to any one of claims 13 or 14, **characterized in that** it comprises a step, called calibration step, comprising measuring and recording a threshold capacitance.

16. Method according to claim 15, **characterized in that** the calibration step comprises a determination of a threshold capacitance taking into account at least one of the following elements: a history measurement, a measurement environment.

17. Method (900) according to any one of claims 11 to 16, **characterized in that** it also comprises a step, called test step, carried out in the absence of the object in order to verify the functioning of the device and comprising the following operations:

- applying the guard potential ($V_g$) to the at least one measurement electrode;
- applying to the at least one second electrode a second potential between the guard potential ($V_g$) and the ground potential (M), or the ground potential (M); and
- determining a capacitance, called electrode-test capacitance, between said measurement electrode and second electrode by measuring a third signal;
- comparing said electrode-test capacitance to a second predetermined threshold capacitance.

**FIG. 1a**

**FIG. 1b**

**FIG. 1c**

**FIG. 2**

**FIG. 3**

**FIG. 4**

$106_1$                    $106_N$                    500

**FIG. 5**

108

$106_1$                    $106_N$                    600

**FIG. 6**

$108_1$                    $108_N$

$106_1$                    $106_N$                    700

**FIG. 7**

$302_1$     $302_1$          $302_N$     $302_N$

$108_1$                    $108_N$

$106_1$                    $106_N$                    800

**FIG. 8**

302     302          302     302

$108_1$                    $108_N$

900

**902** — 904

Mise au potentiel de garde de l'électrode de
mesure et de la deuxième électrode — 904

Mesure du premier signal représentatif de $C_{eo}$ — 906

Calcule de $C_{eo}$ en fonction du premier signal — 908

OUI | $C_{eo} < C_s$ — 910

NON

**912**

Mise au potentiel de masse ou au deuxième
potentiel de la deuxième électrode — 914

Mesure du deuxième signal représentatif de $C_T$ — 916

Calcul de $C_T$ en fonction du deuxième signal — 918

Mesure du premier signal représentatif de $C_{eo}$ — 919

Calcule de $C_{eo}$ en fonction du premier signal — 920

Calcul de $C_{ie}$ — 921

NON | $C_{eo} < C_s$

OUI

## FIG. 9

**EP 3 556 017 B1**

## RÉFÉRENCES CITÉES DANS LA DESCRIPTION

**Documents brevets cités dans la description**

- WO 2013093326 A1